(19) Europäisches Patentamt
European Patent Office
Office européen des brevets

(11) EP 2 578 669 B1

(12) # EUROPEAN PATENT SPECIFICATION

(45) Date of publication and mention of the grant of the patent:
**22.11.2017 Bulletin 2017/47**

(21) Application number: **11789872.6**

(22) Date of filing: **01.06.2011**

(51) Int Cl.:
*C10M 163/00* (2006.01)
*C23C 16/27* (2006.01)
*F16C 33/10* (2006.01)
*C10M 159/18* (2006.01)
*C10N 10/12* (2006.01)
*C10N 30/06* (2006.01)
*C10N 40/25* (2006.01)
*C10N 80/00* (2006.01)
*C10N 10/04* (2006.01)
*C10N 20/02* (2006.01)
*C10N 20/04* (2006.01)
*F16C 33/04* (2006.01)

(86) International application number:
**PCT/JP2011/062630**

(87) International publication number:
**WO 2011/152470 (08.12.2011 Gazette 2011/49)**

(54) **LUBRICATION OF LOW-FRICTION SLIDING MATERIAL**

SCHMIERUNG FÜR EIN REIBUNGSARMES GLEITMATERIAL

LUBRIFICATION D'UN MATÉRIAU DE GLISSEMENT À FAIBLE FROTTEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.06.2010 JP 2010126365**

(43) Date of publication of application:
**10.04.2013 Bulletin 2013/15**

(73) Proprietor: **Idemitsu Kosan Co., Ltd.**
**Chiyoda-ku**
**Tokyo 100-8321 (JP)**

(72) Inventors:
- **WATANABE, Nobuaki**
  **Ichihara-shi**
  **Chiba 299-0107 (JP)**
- **KAJI, Masashi**
  **Ichihara-shi**
  **Chiba 299-0107 (JP)**
- **TSUJIOKA, Masanori**
  **Kyoto-shi**
  **Kyoto 615-8686 (JP)**
- **MIYAKE, Koji**
  **Kyoto-shi**
  **Kyoto 615-8686 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 133 406**
**WO-A1-2006/073198**
**WO-A1-2007/105769**
**WO-A1-2009/119506**
**JP-A- 11 050 079**
**JP-A- 11 092 778**
**JP-A- 2009 215 406**
**JP-A- 2009 235 252**
**JP-A- 2010 065 198**
**US-B2- 6 797 677**

- **"LUBRICANT ADDITIVES - R: T: Vanderbilt Company, Inc", , 1 February 2010 (2010-02-01), XP055095162, Retrieved from the Internet: URL:https://web.archive.org/web/20100215114128/http://www.rtvanderbilt.com/petro/p981.pdf [retrieved on 2014-01-08]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### TECHNICAL FIELD

The present invention relates to the use of a lubricant oil composition for lubricating a low-friction sliding material and to a sliding mechanism using same, and more specifically wherein the lubricant oil composition shows excellent low-friction property and wear resistance for a low-friction sliding material.

### BACKGROUND ART

In recent years, it is important to cope with environmental problems in various fields. Technical development on energy saving and reduction of a discharge amount of carbon dioxide is thus being promoted. In a case of, for example, automobiles, an improvement in fuel consumption is one of the problems, and technical development of lubricating oils and sliding materials becomes important.

As regards lubricating oils, various base oils and additives have so far been developed for the purpose of improving various performances. As performances required to engine oils, there may be mentioned, for example, appropriate viscosity characteristics, oxidation stability, clean dispersibility, abrasion resistance and antifoaming property. These performances are attempted to be improved by combination of various base oils and additives. In particular, zinc dialkyldithiophosphate (ZnDTP) is excellent as an abrasion resistant additive and, therefore, is often used as an additive for engine oils.

As regards sliding materials, on the other hand, materials having a hard film such as a TiN film or a CrN film which contributes to an improvement in an abrasion resistance are known as materials for use in parts which are exposed to severe frictional and abrasive environments (for example, a sliding part of an engine). Further, it is known that a friction coefficient can be reduced in the air in the absence of a lubricating oil by utilizing a diamond-like carbon (DLC) film. Thus, a material having a DLC film (hereinafter referred to as a DLC material) is expected as a low-friction sliding material.

However, the friction reducing effect of a DLC material is occasionally small in the presence of a lubricant oil, and, in this case, a fuel consumption saving effect is less liable to be obtained. In this circumstance, development of various lubricant oil compositions for a low-friction sliding material, typically development of sulfurized oxymolybdenum dithiocarbamate (MoDTC), has so far been carried out.

For example, a lubricant oil composition for a low-friction sliding material which contains an ether base ashless friction reducingagent is disclosed in Patent Document 1. DisclosedinPatent Documents 2 and 3 are techniques in which lubricant oil compositions containing fatty acid ester base ashless friction controlling agents and aliphatic amine base ashless friction controlling agents are used for a sliding face between a DLC member and an iron base member and a sliding face between a DLC member and an aluminum alloy member. Disclosed in Patent Document 4 is a technique in which a low-friction agent composition containing an oxygen-containing organic compound and an aliphatic amine base compound is used in a low-friction sliding mechanism having a DLC coating sliding member. JP2009215406 discloses a lubricant composition that is used for a friction system between a DLC coated material and a metal, exhibits a low coefficient of friction, and is excellent in resistance to wear.

It has been found, however, that these lubricating oils for a low-friction sliding material show very insufficient wear resisting property even when they give a friction reducing effect. For example, when a lubricant oil composition containing MoDTC is used for a DLC material, there is occasionally caused a case where the DLC material is considerably worn. This suggests that in lubricating oils for a low-friction slidingmaterial, it is difficult that they possess both excellent low-friction property and excellent wear resistance. It is without saying that it is essential that a lubricating oil possesses both properties.

Accordingly, there is a demand for a lubricant oil composition which can maintain various performances required to lubricating oils and which shows both excellent low-friction property and excellent wear resisting property when used as a lubricating oil for a low-friction sliding material.

There is also a demand for development of a sliding mechanism which has the aforementioned low-friction sliding material on its sliding face and which is capable of effectively realizing excellent low-friction property and wear resistance.

### PRIOR ART DOCUMENT

Patent Document:

Patent document 1: Japanese Patent Application Publication No. JP2006-036850A

Patent document 2: Japanese Patent Application Publication No. JP2003-238982A
Patent document 3: Japanese Patent Application Publication No. JP2004-155891A
Patent document 4: Japanese Patent Application Publication No. JP2005-098495A

## SUMMARY OF THE INVENTION

Problems to be Solved by the Invention:

The present invention has been made in light of the situations described above and has as its object the use of a lubricant oil composition for lubricating a low-friction sliding material that shows both excellent low-friction property and wear resistance Further, it is an object of the present invention to provide a sliding mechanism which uses the above lubricant oil composition for a low-friction sliding material and which can effectively realize excellent low-friction property and wear resistance.

Means for Solving the Problems:

The present inventors have intensively made repeated studies and found that the above problems may be solved by the use of a lubricant oil composition containing a specific organic molybdenum compound and by allowing the lubricant oil composition to be present between sliding surfaces having a specific low-friction sliding material. The present invention has been completed based on the above finding.
The present invention is defined in and by the appended claims.

Effect of the Invention:

According to the present invention, it is possible to use a lubricant oil composition for lubricating a low-friction sliding material showing both excellent low-friction property and wear resistance. Further, according to the present invention, it is possible to provide a sliding mechanism which uses the lubricant oil composition described above and which can effectively realize both excellent low-friction property and wear resistance.

## BRIEF DESCRIPTION OF THE DRAWINGS

FIG. 1 is a cross-sectional view, schematically showing a structure of a sliding member having a DLC film according to an embodiment of a sliding mechanism of the present invention;
FIG. 2 is a cross-sectional view, schematically showing a structure of a sliding member having a DLC film according to another embodiment of a sliding mechanism of the present invention;
FIG. 3 is a schematic view, showing an outline of a cathode PIG plasma CVD device which is an example of a DLC film forming equipment used in the present invention;
FIG. 4 is a measurement example of anX-raydiffraction spectrum of a DLC film used in the present invention;
FIG. 5 is a differential spectrum of the X-ray diffraction spectrum of DLC film shown in FIG. 4; and
FIG. 6 is a diagram, showing crystal peak extracted from the X-ray diffraction spectrum of the DLC film shown in FIG. 4.

## EMBODIMENTS OF THE INVENTION

The present invention relates to the use of a lubricant oil composition for lubricating a low-friction sliding material and to a sliding mechanism using the above lubricant oil composition, which will be explained below in detail.

1. Lubricant oil composition for lubricating low-friction sliding material

The lubricant oil composition used for lubricating a low-friction sliding material of the present invention (hereinafter occasionally referred to simply as "lubricant oil composition") contains a lubricating oil base oil and a specific compound.
The lubricating oil base oil used in the present invention is not specifically limited, and may be suitably selected from publicly known mineral base oils and synthetic base oils which have so far been used.
Examples of the mineral oils include those which are obtained by subjecting a lube-oil distillate (which is obtained by vacuum distillation of an atmospheric residue produced by atmospheric distillation of a crude oil) to one or more refining treatments such as solvent deasphalting, solvent extraction, hydrocracking, solvent dewaxing, catalytic dewaxing

and hydrorefining, and those which are produced by isomerizing waxes or GTL waxes.

Examples of the synthetic oils include polybutene, polyolefins ($\alpha$-olefin homopolymers and copolymers (such as ethylene-$\alpha$-olefin copolymers)), various esters (such as polyol esters, dibasic acid esters and phosphoric acid esters), various ethers (such as polyphenyl ethers), polyglycols, alkyl benzenes and alkyl naphthalenes. Among these synthetic oils, particularly preferred are poly-$\alpha$-olefins.

In the present invention, the above mineral oils may be used singly or in combination of two or more thereof as the base oil. Also, the above synthetic oils may be used singly or in combination of two or more thereof. Further, one or more mineral oils may be used in combination with one or more synthetic oils.

The viscosity of the base oil is not specifically limited and may vary according to the intendeduse of the lubricant oil composition. However, it is preferred that the base oil have a kinematic viscosity at 100°C of 2 to 30 $mm^2/s$, more preferably 2.5 to 15 $mm^2/s$, still more preferably 3.5 $mm^2/s$ to 10 $mm^2/s$. When the kinematic viscosity at 100°C is 2 $mm^2/s$ or more, an evaporation loss is small. When the kinematic viscosity at 100°C is 30 $mm^2/s$ or less, a power loss by viscosity resistance is less liable to become large so that a fuel consumption improving effect is obtainable.

It is also preferred that the base oil have a sulfur content (as measured according to JIS K 2541) of 50 ppm by mass or less. When the sulfur content is 50 ppm by mass or less, an effect of increasing wear resistance of a low-friction sliding material may be obtained. The sulfur content is more preferably 30 ppm by mass or less, still more preferably 20 ppm by mass or less.

It is also preferred that the base oil have $\%C_A$ of 3.0 or less as measured by ring analysis. As used herein, the term "$\%C_A$ as measured by ring analysis" means a proportion (percentage) of aromatic components which is calculated by the n-d-M ring analysis method. The base oil having $\%C_A$ of 3.0 or less exhibits good oxidation stability. The $\%C_A$ value of the base oil is more preferably 1.0 or less, still more preferably 0.5 or less.

It is further preferred that the above base oil have a viscosity index of 70 or more, more preferably 100 or more and still more preferably 120 or more. When the viscosity index is 70 or more, a viscosity change of the base oil by a change in temperature is small so that a stable lubricating performance is obtainable.

In the present invention, use is made of an organic molybdenum compound which contains at least one nitrogen (N) atom in the molecule and which may optionally contain a sulfur (S) atom, a sulfur content of the organic molybdenum compound being 0.5% by mass or less based on the organic molybdenum compound. A lubricant oil composition containing the organic molybdenum compound has an effect of imparting excellent low-friction property and wear resistance to a low-friction sliding material.

Thus, the organic molybdenum compound used in the present invention must have a sulfur content of 0.5% by mass or less based on the organic molybdenum compound. When the sulfur content of the organic molybdenum compound exceeds 0.5% by mass based on the organic molybdenum compound, the wear resistance to be imparted to a low-friction sliding material is deteriorated. The sulfur content of the organic molybdenum compound is preferably 0.3% by mass or less. The organic molybdenum compound used in the present invention has a mass ratio (p/q) of its nitrogen content (p) to its molybdenum content (q) of 0.05 or more and 1.0 or less for reasons that further excellent low-friction property may be obtained. When the mass ratio (p/q) of the nitrogen content (p) to the molybdenum content (q) is less than 0.05, there is a possibility that the stability of the compound is reduced. When the mass ratio exceeds 1.0, there is a possibility that the friction reducing effect is lowered. From this point of view, the mass ratio (p/q) of the nitrogen content (p) to the molybdenum content (q) is more preferably 0.1 or more and 0.8 or less.

Such an organic molybdenum compound is not specifically limited and may be, for example, at least one compound selected from the group consisting of (a) reaction products of a molybdenum compound and an amine compound, (b) reaction products of a molybdenum compound and an organic compound containing at least either one of a fatty acid and a fatty acid derivative, and at least one amino group; and products obtained by sulfurizing the reaction products, and (c) reaction products of an acidic molybdenum compound or a salt thereof and a succinimide or carboxylic acid amide; and products obtained by sulfurizing the reaction products.

(a) The reaction products of a molybdenum compound and an amine compound may be obtained by reaction of a hexavalent molybdenum compound, to be more specific, molybdenum trioxide and/or molybdic acid, with an amine compound by a production method such as described in Japanese Patent Application Publication No. JP2003-252887A.

The amine compound to be reacted with the hexavalent molybdenum compound is not particularly limited, and there may be mentioned monoamines, diamines, polyamines and alkanol amines. Specific examples of the amine compound include alkyl amines having an $C_1$ to $C_{30}$ alkyl group or groups (the alkyl group may be either linear or branched) such as methylamine, ethylamine, propylamine, butylamine, pentylamine, hexylamine, heptylamine, octylamine, nonylamine, decylamine, undecylamine, dodecylamine, tridecylamine, tetradecylamine, pentadecylamine, hexadecylamine, heptadecylamine, octadecylamine, dimethylamine, diethylamine, dipropylamine, dibutylamine,

dipentylamine, dihexylamine, diheptylamine, dioctylamine, dinonylamine, didecylamine, diundecylamine, didodecylamine, ditridecylamine, ditetradecylamine, dipentadecylamine, dihexadecylamine, diheptadecylamine, dioctadecylamine, methylethylamine, methylpropylamine, methylbutylamine, ethylpropylamine, ethylbutylamine, and propylbutylamine; alkenyl amines containing a $C_2$ to $C_{30}$ alkenyl group or groups (the alkenyl group may be linear or branched) such as ethenyl amine, propenyl amine, butenyl amine, octenyl amine and oleyl amine; alkanol amines containing a $C_1$ to $C_{30}$ alkanol group or groups (the alkanol group may be linear or branched) such as methanol amine, ethanol amine, propanolamine, butanolamine, pentanolamine, hexanolamine, heptanolamine, octanolamine, nonanolyamine, methanolethanolamine, methanolpropanolamine, methanolbutanolamine, ethanolpropanolamine, ethanolbutanolamine, and propanolbutanolamine; alkylene diamines containing a $C_1$ to $C_{30}$ alkylene group or groups such as methylenediamine, ethylenediamine, propylenediamine and butylenediamine; polyamines such as diethylenetriamine, triethylenetetramine, tetraethylenepentamine and pentaethylenehexamine; compounds, such as undecyldiethylamine, undecyldiethanol amine, dodecyldipropanol amine, oleyldiethanol amine, oleylpropylenediamine and stearyltertraethylenepentamine, which are obtained by further introducing a $C_8$ to $C_{20}$ alkyl or alkenyl group into the above monoamines, diamines or polyamines; heterocyclic compounds such as imidazoline; alkyleneoxide adducts of these compounds; and mixtures of these compounds. Of those amine compounds, primary amines, secondary amines, and alkanol amines are preferable.

A carbon number of the hydrocarbon group contained in these amine compounds is preferably 4 or more, more preferably 4 to 30, and particularly preferably 8 to 18. When the carbon number of the hydrocarbon group of the amine compound is less than 4, solubility thereof tends to deteriorate. Further, when the carbon number of the amine compound is 30 or less, a molybdenum content in the reaction products canbe relatively increased, and thus, a small amount thereof can enhance the effect. These amine compounds may be used alone, or two or more thereof may be used in combination.

Regarding a reaction ratio of the hexavalent molybdenum compound to the amine compound, a molar ratio of Mo atom of the molybdenum compound to 1 mol of the amine compound is preferably 0.7 to 5, more preferably 0.8 to 4, and still more preferably 1 to 2.5. The reaction method is not particularly limited, and a conventionally known method, for example, a method described in JP2003-252887A may be adopted.

(b) The reaction products of a molybdenum compound and an organic compound containing at least either one of a fatty acid and a fatty acid derivative, and at least one amino group; may be prepared by various methods. For example, the reaction product disclosed in Japanese patent No. 2, 757,174 is obtainable by reacting a molybdenum source with a diol, diamino or amino alcohol compound, disclosed in U. S. patent No. 5,412,130 in the presence of an interphase transfer catalyst. U. S. patent No. 4,889,647 discloses a reaction product of a fatty oil, diethanolamine and a molybdenum source, and U. S. patent No. 5,137,647 discloses a reaction product of a fatty acid derivative of 2-(2-aminoethyl)aminoethanol and a molybdenum source.

Japanese patent No. 3,291,339 discloses a reaction product obtained by reaction of a fatty acid derivative of a fatty acid derivative of 2- (2-aminoethyl) aminoethanol and a molybdenum source may be obtained by reaction of a molybdenum source with an amine-amide intermediate that is produced by hydrolysis of 1-(2-hydroxyethyl)-2-imidazoline.

Japanese patent No. 4,109,428 discloses a reaction product which comprises fatty oils, a mono-alkylated alkylene diamine, and a molybdenum source. Preferred is a method in which fatty oils and a mono-alkylated alkylene diamine are reacted at an elevated temperature to obtain an aminoamide/glyceride mixture (first step), followed by reaction with the molybdenum source (second step). Examples of the fatty oil include glyceryl esters of fatty acids, triacylglycerols or triglycerides. The diamine is a mono-alkylated alkylene diamine which is capable of reacting with the fatty oils and which permits its intermediate, i.e. aminoamide/glyceride mixture, to react with the molybdenum source. As the molybdenum source, there may be mentioned ammonium molybdate, sodium molybdate, molybdenum oxides and mixtures thereof. Particularly preferred molybdenum source is molybdenum trioxide.

Japanese patent No. 4,109,429 discloses a reaction product which comprises a reaction product of a long chain monocarboxylic acid, a mono-alkylated alkylene diamine, a glyceride and a molybdenum source. The chain monocarboxylic acid has preferably at least 8 carbon atoms, more preferably at least 12 carbon atoms. As the molybdenum source, there may be mentioned ammonium molybdate, sodium molybdate, molybdenum oxides and mixtures thereof.

The foregoing reaction products may be further sulfurized by a method disclosed in Japanese patent application publication No. JP2004-002866A.

(c) The reaction products of an acidic molybdenum compound or a salt thereof and a succinimide or carboxylic acid amide, and products obtained by sulfurizing the reaction products may be produced by the reaction process disclosed in Japanese patent application publication No. JP2004-002866A.

It is preferred that a content of sulfur, which is derived from the above-described organic molybdenum compound,

in the lubricant oil composition be 100 ppm by mass or less based on a total weight of the composition. The blending amount of the above-described organic molybdenum compound in the lubricant oil composition of is 0.03 to 0.2% by mass, in terms of molybdenum based on a total weight of the composition. When the blending amount is 0.02% by mass or more, both low-friction property and good wear resistance may be obtained.

It is also preferred that the lubricant oil composition contain a zinc organodithiophosphate in addition to the above organic molybdenum compound. By using the organic molybdenum compound in conjunction with the zinc organodithiophosphate,moreimprovedlow-friction property and wear resistance may be imparted to a low-friction sliding member.

As the zinc organodithiophosphate, a compound represented by the following general formula (I) may be used.

[Chemical Formula 1]

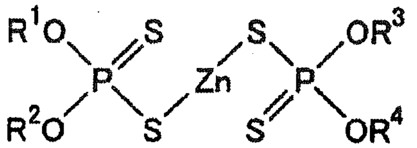

(I)

In the general formula (I), $R^1$, $R^2$, $R^3$ and $R^4$ each independently represent a hydrocarbon group having 1 to 24 carbon atoms. Such a hydrocarbon group is preferably a straight-chained or branched alkyl group having 1 to 24 carbon atoms, a straight-chained or branched alkenyl group having 3 to 24 carbon atoms, a cycloalkyl group or a straight-chained or branched alkylcycloalkyl group having 5 to 13 carbon atoms, an aryl group or a straight-chained or branched alkylaryl group having 6 to 18 carbon atoms, or an arylalkyl group having 7 to 19 carbon atoms. The above alkyl group and alkenyl group may be any of primary, secondary and tertiary groups.

In the present invention the hydrocarbon groups $R^1$, $R^2$, $R^3$ and $R^4$ preferably include a secondary alkyl group. Illustrative of suitable zinc organodithiophosphates are zinc di-sec-butyldithiophosphate, zinc di-sec-pentyldithiophosphate, zinc di-sec-hyxyldithiophosphate and mixtures of any combination of them.

In the lubricant oil composition, the blending amount of the above zinc organodithiophosphate is preferably 0.005% by mass or more in terms of phosphorus content. When the blending amount is 0.005% by mass or more, low-friction property and abrasion resistance may be improved. The blending amount is more preferably 0.01% by mass ormore, still more preferably 0.02% by mass or more.

Into the lubricant oil composition, various additives such as a viscosity index-improver, a pour point depressant, a detergent dispersant, an antioxidant, a wear resisting agent or an extreme pressure agent, a friction-reducing agent, a dispersing agent, a rust inhibitor, a surfactant or an anti-emulsifier, and an antifoaming agent, may be added, as needed, as long as the object of the invention is not adversely affected.

As the viscosity index improver, there may be mentioned, for example, polymethacrylates, dispersion type polymethacrylates, olefin-based copolymers (such as ethylene-propylene copolymers), dispersion type olefin-based copolymers and styrene-based copolymers (such as styrene-diene copolymers and styrene-isoprene copolymers).

The blending amount of the viscosity index improver is preferably 0.5% to 15% by mass, more preferably 1% to 10% by mass, based on the total amount of the lubricant oil composition from the standpoint of effects attained by addition thereof.

As the pour point depressant, there may be mentioned, for example, polymethacrylates havingaweight-averagemolecularweight of about 5,000 to about 50,000.

The blending amount of the pour point depressant is generally 0.1% to 2% by mass, more preferably 0.1% to 1% by mass, based on the total amount of the lubricant oil composition from the standpoint of effects attained by addition thereof.

As the above-mentioned detergent dispersant, there may be used an ashless dispersant and a metallic detergent. Any ashless dispersant used for lubricating oils may be used. Examples of the ashless dispersant include a mono-type succinimide compound represented by the following general formula (II) or a bis-type succinimide compound represented by the following general formula (III):

[Chemical formula 2]

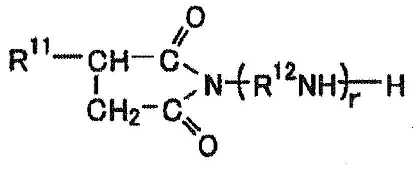

(II)

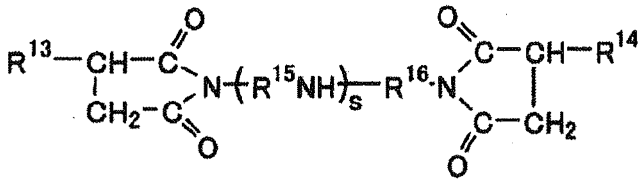

(III)

In the above general formulas (II) and (III), $R^{11}$, $R^{13}$ and $R^{14}$ each represent an alkenyl or alkyl group having a number-average molecular weight of 500 to 4,000. The groups and $R^{13}$ and $R^{14}$ may be the same or different. The number-average molecular weight of $R^{11}$, $R^{13}$ and $R^{14}$ is preferably from 1,000 to 4,000.

In the formulas, $R^{12}$, $R^{15}$ and $R^{16}$ each represent a $C_2$ to $C_5$ alkylene group. The groups $R^{15}$ and $R^{16}$ may be the same or different. The symbol r is an integer of 1 to 10, s is 0 or an integer of 1 to 10.

When the number-average molecular weight of $R^{11}$, $R^{13}$ and $R^{14}$ is less than 500, there is a possibility that the solubility of the compound in the base oil is reduced. When the number-average molecular weight exceeds 4,000, the detergency reduced and there is a fear of failure to achieve the desired performance. The symbol r is preferably 2 to 5, more preferably 3 or 4. When r is less than 1, there is a possibility that the detergency is deteriorated. When r is 11 or more, there is a possibility that the solubility in the base oil is deteriorated.

Further, in the general formula (III), s is preferably 1 to 4, more preferably 2 or 3. The symbol s that lies within the above-specified range is preferred for reasons of the detergency and solubility in the base oil.

Examples of the alkenyl group include a polybutenyl group, a polyisobutenyl group and an ethylene-propylene copolymer group. Examples of the alkyl group include those which are obtained by hydrogenating these alkenyl groups. Typical examples of the suitable alkenyl group include a polybutenyl group and a polyisobutenyl group. The polybutenyl group may be obtained by polymerizing a mixture of 1-butene and isobutene, or high-purity isobutene. Typical examples of the suitable alkyl group include those which are obtained by hydrogenating a polybutenyl group and a polyisobutenyl group.

The above alkenylsuccinimide compound or alkylsuccinimide compound may be generally produced by reacting a polyamine with an alkenylsuccinic anhydride obtained by reaction of a polyolefin with maleic anhydride, or with an alkylsuccinic anhydride, obtained by hydrogenating the alkenylsuccinic anhydride. Also, the above mono-type succinimide compound or bis-type succinimide compound may be produced by varying a reaction ratio between the alkenylsuccinic anhydride or alkylsuccinic anhydride and the polyamine.

As an olefin monomer from which the above polyolefin is formed, there may be used a $C_2$ to $C_8$ $\alpha$-olefin or a mixture of two or more thereof. Among them, a mixture of isobutene and butene-1 may be suitably used.

Examples of the polyamine include primary diamines such as ethylenediamine, propylenediamine, butylenediamine and pentylenediamine; polyalkylene polyamines such as diethylenetriamine, triethylenetetramine, tetraethylenepentamine, pentaethylenehexamine, di(methylethylene)triamine, dibutylenetriamine, tributylenetetramine and pentapentylenehexamine; and piperazine derivatives such as aminoethylpiperazine.

In addition to the above alkenyl or alkylsuccinimide compound, there may also be used boron derivatives thereof and/or organic acid-modified products thereof as the ashless dispersant. The boron derivatives of the alkenyl- or alkylsuccinimide compound may be produced by an ordinary method.

For example, the boron derivatives may be produced by first reacting the above polyolefin with maleic anhydride to obtain an alkenylsuccinic anhydride, and then reacting the resulting alkenylsuccinic anhydride with an intermediate product obtained by reacting the above polyamine with a boron compound, such as boron oxide, a boron halide, boric acid, boric anhydride, a boric acid ester and an ammonium salt of orthoboric acid, to imidize the alkenylsuccinic anhydride.

The content of boron in the boron derivatives is not particularly limited, and is preferably in the range of 0.05 to 5% by mass, more preferably 0.1 to 3% by mass, in terms of boron element.

The blending amount of the mono-type succinimide compound represented by the general formula (II) or a bis-type succinimide compound represented by the general formula (III) is preferably 0.5 to 15% by mass, more preferably 1 to 10% by mass, based on a total amount of the lubricant oil composition. When the blending amount is less than 0.5%

by mass, the desired effect is not easily obtained. When the compounding amount exceeds 15% by mass, no additional effect proportional to the blending amount may not be occasionally obtained. As long as the above-specified amount is met, the succinimide compound may be used singly or a combination of two or more thereof.

As the metallic detergent, there may be used any alkaline earth metal-based detergents which are employed for ordinary lubricant oils. Examples of the alkaline earth metal-based detergent include alkaline earth metal sulfonates, alkaline earth metal phenates, alkaline earth metal salicylates and mixtures of two or more thereof.

As the alkaline earth metal sulfonates, there may be mentioned alkaline earthmetal salts of an alkyl aromatic sulfonic acid obtained by sulfonating an alkyl aromatic compound having a molecular weight of 300 to 1, 500, preferably 400 to 700. Among them, magnesium salts and/or calcium salts, especially calcium salts are preferred.

As the alkaline earth metal phenates, there may be mentioned alkaline earth metal salts of alkylphenols, alkylphenol sulfides and Mannich reaction products of alkylphenols. Among them, magnesium salts and/or calcium salts, especially calcium salts are preferred.

As the alkaline earth metal salicylates, there maybe mentioned alkaline earth metal salts of alkyl salicylic acids. Among them magnesium salts and/or calcium salts, especially calcium salts are preferred.

The alkyl group constituting the above alkaline earth metal-based detergents is preferably a $C_4$ to $C_{30}$ alkyl group, more preferably a $C_6$ to $C_{18}$ linear or branched alkyl group. These alkyl groups may be straight chained or branched. These alkyl groups may be primary alkyl groups, secondary alkyl groups or tertiary alkyl groups.

As the alkaline earth metal sulfonates, alkaline earth metal phenates and alkaline earth metal salicylates, there may be used neutral alkaline earth metal sulfonates, neutral alkaline earth metal phenates and neutral alkaline earth metal salicylates which maybeproducedby directly reacting the above alkyl aromatic sulfonic acids, alkylphenols, alkylphenol sulfides, Mannich reaction products of alkylphenols, alkyl salicylic acids or the like with an alkaline earth metal base such as an oxide or a hydroxide of an alkaline earth metal such as magnesium and/or calcium or which may be produced by once forming an alkali metal salt such as sodium salt and potassium salt and then converting the alkali metal salt into an alkaline earth metal salt. Further, there may also be used basic alkaline earth metal sulfonates, basic alkaline earth metal phenates and basic alkaline earth metal salicylates which may be produced by heating neutral alkaline earth metal sulfonates, neutral alkaline earth metal phenates and neutral alkaline earth metal salicylates together with an excess amount of an alkaline earth metal salt or an alkaline earth metal base in the presence of water. Furthermore, there may also be used perbasic alkaline earth metal sulfonates, perbasic alkaline earth metal phenates and perbasic alkaline earth metal salicylates which may be produced by reacting neutral alkaline earth metal sulfonates, neutral alkaline earth metal phenates and neutral alkaline earth metal salicylates with an alkaline earth metal carbonate or an alkaline earth metal borate in the presence of carbon dioxide.

The metallic detergent used in the present invention may be selected from the above-described neutral salts, basic salts, perbasic salts and mixtures these salts and is preferably a mixture of a neural sulfonate with at least one of perbasic salicylates, perbasic phenates and perbasic sulfonates, for reasons of detergency and wear resistance.

The total base number of the metallic detergent used in the present invention is preferably 10 to 500 mg KOH/g, more preferably 15 to 450 mg KOH/g. The metallic detergent may be selected from these detergents and used singly or in combination of two or more thereof. The term "total base number" as used herein means the value as measured by a potentiometric titration method (base number/perchlorate method) according to the Item 7 of JIS K 2501 "Petroleum Products and Lubricants-Neutralization Number Testing Method."

The metal ratio of the metallic detergent used in the present invention is not specifically limited. The metallic detergent having a metal ratio of 20 or less may be generally used singly or as a mixture of two or more thereof. The metallic detergent having a metal ratio of preferably 3 or less, more preferably 1.5 or less, still more preferably 1.2 or less, is particularly suitably used for reasons of further improved oxidation stability, base number retention property, high-temperature detergency, etc. Meanwhile, the term "metal ratio" as used herein means a ratio represented by the formula: [valence of a metal element] x [content (mol%) of the metal element] / [content (mol%) of a soap group], wherein the metal element is calcium, magnesium, etc., and the soap group is a sulfonic group, a phenol group, a salicylic group, etc.

The metallic detergent is generally commercially available in a state diluted with, for example, a light lubricating oil base oil. It is desirable that a commercial product having a metal content of preferably 1.0 to 20% by mass, more preferably 2.0 to 16% by mass, be used.

The blending amount of the metallic detergent is preferably 0.01% to 20% by mass, more preferably 0.1% to 10% by mass, based on the total amount of the lubricant oil composition. A compounding amount of the metallic detergent less than 0.01% by mass is not preferable because performances are not easily obtainable. When the amount of the metallic detergent compounded is more than 20% by mass, an effect proportional to the blending amount of the metallic detergent may not be obtained. The metallic detergent may be used singly or in combination of two or more thereof as long as the content thereof lies within the above-specified range.

The antioxidant includes phenol base antioxidants, amine base antioxidants and sulfur base antioxidants. The phenol base antioxidants include, for example, 4,4'-methylenebis(2,6-di-t-butylphenol); 4,4'-bis(2,6-di-t-butylphenol);

4,4'-bis(2-methyl-6-t-butylphenol); 2,2'-methylenebis(4-ethyl-6-t-butylphenol); 2,2'-methylenebis(4-methyl-6-t-butylphenol); 4,4'-butylidenebis(3-methyl-6-t-butylphenol); 4,4'-isopropylidenebis(2,6-di-t-butylphenol); 2,2'-methylenebis(4-methyl-6-nonylphenol); 2,2'-isobutylidenebis(4,6-dimethylphenol); 2,2'-methylenebis(4-methyl-6-cyclohexylphenol); 2,6-di-t-butyl-4-methylphenol; 2,6-di-t-butyl-4-ethylphenol; 2,4-dimethyl-6-t-butylphenol; 2,6-di-t-amyl-p-cresol; 2,6-di-t-butyl-4-(N,N'-dimethylaminomethylphenol; 4,4'-thiobis(2-methyl-6-t-butylphenol); 4,4'-thiobis(3-methyl-6-t-butylphenol); 2,2'-thiobis(4-methyl-6-t-butylphenol); bis(3-methyl-4-hydroxy-5-t-butylbenzyl)sulfide; bis(3,5-di-t-butyl-4-hydroxybenzyl)sulfide; n-octadecyl-3-(4-hydroxy-3,5-di-t-butylphenyl)propionate; 2,2'-thio[diethyl-bis-3-(3,5-di-t-butyl-4-hydroxyphenyl)propio nate] and the like. Among them, bisphenol base and ester group-containing phenol base antioxidants are particularly preferred.

The amine base antioxidants include, for example, monoalkyldiphenylamines such as monooctyldiphenylamine, monononyldiphenylamine and the like; dialkyldiphenylamines such as 4,4'-dibutyldiphenylamine, 4,4'-dipentyldiphenylamine, 4,4'-dihexyldiphenylamine, 4,4'-diheptyldiphenylamine, 4,4'-diocyldiphenylamine, 4,4'-dinonyldiphenylamine and the like; polyalkyldiphenylamines such as tetrabutyldiphenylamine, tetrahexyldiphenylamine, tetraocyldiphenylamine, tetranonyldiphenylamine and the like; naphthyl amine base antioxidants, to be specific, $\alpha$-naphthylamine, phenyl-$\alpha$-naphthylamine and alkyl-substituted phenyl-$\alpha$-naphthylamines such as butylphenyl-$\alpha$-naphthylamine, pentylphenyl-$\alpha$-naphthylamine, hexylphenyl-$\alpha$-naphthylamine, heptylphenyl-$\alpha$-naphthylamine, octylphenyl-$\alpha$-naphthylamine, nonylphenyl-$\alpha$-naphthylamine and the like. Among them, the dialkyldiphenylamine base antioxidants and the naphthylamine base antioxidants are suited.

As the sulfur-based antioxidant, there may be mentioned, for example, phenothiazine, pentaerythritol-tetrakis-(3-lauryl thiopropionate), didodecylsulfide, dioctadecyl sulfide, didodecyl thiodipropionate, dioctadecyl thiodipropionate, dimyristyl thiodipropionate, dodecyloctadecyl thiodipropionate and 2-mercaptobenzoimidazole. The blending amount of the antioxidant is preferably 0.1 to 5% by mass, more preferably 0.1 to 3% by mass, based on the total amount of the lubricant oil composition.

As the friction reducing agent, any compound that is generally used as a friction reducing agent for a lubricating oil may be used. Examples of the friction reducing agent include ashless friction reducing agents such as compounds containing at least one $C_6$ to $C_{30}$ alkyl or alkenyl group in the molecule thereof, e.g. fatty acid esters, fatty acid amides, fatty acids, aliphatic alcohols, aliphatic amines and aliphatic ethers. The blending amount of the friction reducing agent is preferably 0.01 to 2% by mass, more preferably 0.01% to 1% by mass, based on the total amount of the lubricant oil composition.

As the metal deactivator, there maybe mentioned, for example, benzotriazole-based compounds, tolyl triazole-based compounds, thiadiazole-based compounds and imidazole-based compounds.

The blending amount of the metal deactivator is preferably 0.01% to 3% by mass, more preferably 0.01% to 1% by mass, based on the total amount of the lubricant oil composition.

As the rust inhibitor, there may be mentioned, for example, petroleum sulfonates, alkylbenzene sulfonates, dinonylnaphthalene sulfonates, alkenylsuccinic acid esters and polyhydric alcohol esters. The blending amount of the rust inhibitor is preferably 0.01% to 1% by mass, more preferably 0.05% to 0.5% by mass, based on the total amount of the lubricant oil composition from the standpoint of effects attained by addition thereof.

As the surfactant or antiemulsifying agent, there may be mentioned polyalkylglycol-based nonionic surfactants such as polyoxyethylene alkyl ether, polyoxyethylene alkylphenyl ether and polyoxyethylene alkylnaphthyl ether. The blending amount of the surfactant or antiemulsifying agent is preferably 0.01% to 3% by mass, more preferably 0.01% to 1% by mass, based on the total amount of the lubricant oil composition

As the antifoaming agent, there may be mentioned, for example, silicon oils, fluorosilicone oils and fluoroalkyl ethers. From the standpoint of antifoaming effect and economy, the antifoaming agent is preferably used in an amount of 0.005 to 0.5% by mass, more preferably 0.01 to 0.2% by mass, based on the total amount of the gear oil composition.

The lubricant oil composition is applied to a sliding face having a low-friction sliding material and can impart excellent low-friction property and excellent abrasion resistance thereto. Especially when applied to internal combustion engines, the lubricant oil composition can achieve a fuel consumption-saving effect.

The sliding face having a low-friction sliding material described above is a sliding face which has a DLC material as the low-friction sliding material and which constitutes at least one of the sliding faces. In this case, a material of the other sliding face maybe, for example, a DLC material, an iron base material and an aluminum alloy material.

That is, examples of the combination of two sliding faces are a constitution in which both of the two sliding faces are the DLC materials, a constitution in which one sliding face is the DLC material and the other sliding face is the iron base material, and a constitution in which one sliding face is the DLC material and the other sliding face is the aluminum alloy material.

Here, as one embodiment of the sliding face having a DLC material, there may be mentioned a structure in which a DLC film is provided on a surface of the sliding face. The DLC material constituting the DLC film may be made of an amorphous material constituted mainly of a carbon element, in which a bonding form of carbons comprises both of a diamond structure ($SP^3$ bond) and a graphite structure ($SP^2$ bond).

To be specif ic, DLC may include a-C (amorphous carbon) composed only of carbon elements, a-C:H (hydrogenated amorphous carbon) containing hydrogen and MeC containing partially a metal element such as titanium (Ti), molybdenum (Mo) and the like.

Among them, a-C:H (hydrogenated amorphous carbon), specifically a-C:H containing 5 to 50% of hydrogen or DLC W is preferred.

Further, DLC material is preferably DLC showing a graphite crystal peak in an X-ray scattering spectrum.

The above DLC having such a graphite crystal peak may be formed by a cathode PIG (Penning Ionization Gauge) plasma CVD method in a high density plasma environment.

As the iron base material, on the other hand, there may be mentioned, for example, carburized steel SCM420 and SCr420 (JIS). As the aluminum alloy material, it is preferable to use a hypoeutectic aluminum alloy or a hypereutectic aluminum alloy containing 4 to 20% by mass of silicon and 1.0 to 5.0% by mass of copper. To be more specific, there may be mentioned, for example, AC2A, AC8A, ADC12, ADC14 (JIS).

It is also preferred that the DLC material and the iron base material, or the DLC material and the aluminum alloy material each have a surface roughness of 0.1 $\mu$m or less in terms of an arithmetic average roughness from the viewpoint of stable sliding. When the roughness is 0.1 $\mu$m or less, local scuffing is less liable to be formed, and an increase of friction coefficient can be inhibited. It is further preferred that the DLC material described above has a surface hardness of HV 1,000 to 3,500 in terms of a micro-Vickers hardness (98 mN load) and a thickness of 0.3 to 2.0 $\mu$m.

On the other hand, the iron base material described above has preferably a surface hardness of HRC 45 to 60 in terms of a Rockwell hardness (C scale). This is effective because, the durability of the film can be maintained even exposed to a sliding condition of about 700 MPa under a high face pressure as is the case with a cam follower. Also, the aluminum alloy material described above preferably has a surface hardness of HB 80 to 130 in terms of a Brinell hardness.

When the surface hardness and thickness of the DLC material fall within the ranges described above, abrasion and peeling may be inhibited. Further, when the surface hardness of the iron base material is HRC 45 or more, it is possible to inhibit buckling and peeling under a high face pressure. On the other hand, when the surface hardness of the aluminum alloy material falls within the range described above, the aluminum alloy material is inhibited from being abraded.

The sliding part to which the lubricant oil composition of the present invention is applied shall not specificallybe restricted as long as it has a surface in which two metal surfaces are brought into contact with each other and in which at least one of them has a low-friction sliding material. A sliding part of an internal combustion engine may be mentioned as a preferred example thereof. In this case, more excellent low-friction property and abrasion resistance as compared with conventional technique is obtained. And this is effective because the fuel consumption saving effect is also exerted. As the DLC member (sliding member having a DLC film), there may be mentioned, for example, disc like shims and lifter crestal planes each having a coating of DLC on a base plate of a steel material. Examples of the iron base material include cam lobes formed of low alloy chilled cast iron, a carburized steel or a thermally refined carbon steel, or any combination thereof.

2. Sliding Mechanism

The sliding mechanism of the present invention is one in which the lubricant oil composition described above is allowed to be present between two sliding faces, wherein at least one of the sliding faces is provided with a DLC film. The DLC film preferably contains 5 to 50 atom % of hydrogen. Especially, the DLC film described above is more preferably a DLC film having a graphite crystal peak in an X-ray scattering spectrum thereof.

An embodiment in which the DLC film described above is a DLC film having a graphite crystal peak in its X-ray scattering spectrum will be explained below with reference to the drawings.

FIG. 1 is a cross-sectional view schematically showing a structure of a sliding member having a DLC film according to one embodiment a sliding mechanism of the present invention, and FIG. 2 is a cross-sectional view schematically showing a structure of the a sliding member having a DLC film according to another embodiment of a sliding mechanism the present invention.

Referring to FIG. 1 and FIG. 2, designated as 1 is a base material, 3 is a DLC film and 4 is a graphite crystal. An intermediate layer 2 is provided as an adhesive layer between the base material 1 of a sliding material and the DLC film 3.

A primer layer 21 may be provided, as shown in FIG. 2, as a second intermediate layer between the base material 1 and the intermediate layer 2. An adhesive property of the base material 1 with the intermediate layer 2 can be further enhanced by providing the primer layer 21.

The above DLC film having a peak of a graphite crystal may be formed by a cathode PIG (Penning Ionization Gauge) plasma CVD method in a high density plasma environment.

To be specific, a plasma generated, for example, in a cathode PIG is shut in a magnetic field formed by a coil,

whereby the plasma is densified. Thus, a raw material gas is decomposed into active atoms, molecules and ions at a high efficiency. Further, a direct current pulse is applied onto the base material while piling up the highly active raw material gas components, whereby high energy ions can be irradiated. This makes it possible to efficiently form a DLC film which is excellent in a sliding characteristic. In respect to details of the forming method, a method described in Japanese Patent Application No. 2008-335718 is preferred.

FIG. 3 is a diagram showing an outline of one example of the cathode PIG plasma CVD device described above. In FIG. 3, designated as 40 is a chamber; 41 is a base material; 42 is a holder; 43 is a plasma source; 44 is an electrode; 45 is a coil; 46 is a cathode; 47 is a gas introducing port; 48 is a gas discharge port; 49 is a bias electric source; and 50 is a plasma formed in the chamber 40. The DLC film can be formed in the following manner by using the device described above.

First, the base material 41 which is supported by the holder 42 is disposed in the chamber 40. Next, Ar gas is injected from the gas introducing port 47, and the plasma 50 is generated and stabilized by using the plasma source 43, the electrode 44 and the coil 45. The Ar gas decomposed in the plasma is attracted to the base material 41 by the bias electric source 49 to carry out surface etching. Then, a metal layer which is a primer layer is formed by using the cathode 46 comprising metal and the Ar gas. Further, a raw material gas injected from the gas introducing port 47 is decomposed and reacted in a high density plasma atmosphere to thereby form graphite crystal in the DLC film. This is maintained as is until the DLC film having a prescribed thickness is obtained. In this case, a crystal diameter of the graphite crystal is controlled so that the diameter becomes 15 to 100 nm.

In the cathode PIG plasma CVD device described above, the characteristics of the DLC film obtained may be changed by changing the plasma characteristics and the kind of gases, and the sliding property and the durability may be improved by optimizing an amount of the graphite crystal and a hardness, a surface roughness and the like of the DLC film in addition to a crystal diameter of the graphite crystal described above.

The presence of the graphite crystal in the DLC film formed and the crystal diameter are preferably confirmed by using X-ray diffraction measurement shown below.

Generally, a plural number of sharp diffraction peaks corresponding to the respective lattice planes are present in an X-ray diffraction spectrum of a crystal material, and a crystal structure thereof is usually determined by checking the above peaks. In contrast to this, in a case of the preferred DLC film of the present invention, the diffraction peaks of the graphite crystal are present among scattered broad peaks which are inherent to an amorphous material and called halo patterns.

FIG. 4 shows an example of an X-ray diffraction spectrum of the DLC film containing graphite crystal. The X-ray diffraction spectrum was as measured under the following conditions: Measurement Conditions:

X-ray source: radiant light source
X-ray energy: 15 KeV
Incident slit width: 0.1 mm
Detector: scintillation counter (a solar slit is placed in a front stage)
Measuring range of scattering angle 2$\theta$: 5 to 100°
Measuring step: 0.1°
Integration time: 30 seconds/step

The DLC film sample was peeled off from the base plate, and it was filled into a narrow glass tube (capillary) and measured.

As shown in FIG. 4, since the main components of the preferred DLC film in the present invention are amorphous, the intensity of diffract ion peaks of the graphite crystal is occasionally relatively weak. Even in the above case, the presence of the main crystal peaks can be confirmed by using a differential spectrum which is widely used in analytical chemistry. A differential spectrum of the same DLC film sample as used in FIG. 4 is shown in FIG. 5.

In the embodiment of the present invention, largest 10 peaks are selected amongpeaks that are present in the differential spectrum. When there are at least 3 peaks which coincide with the peak positions of the graphite crystal, the, the DLC film is judged to contain the graphite crystal. The above method is based on a Hanawalt method used in X-ray diffraction of ordinary crystal materials, that is, a method for characterizing diffraction patterns by using three (3) most intense peaks in the pattern.

Further, the crystal diameter of the graphite crystal may be estimated from broadening of the diffraction peaks shown above. To be more specific, the crystal diameter may be determined by deducting halo patterns attributed to amorphous components as a background from the X-ray diffraction spectrum to extract graphite crystal peaks, followed by applying a Scherrer equation shown by Equation 1. The result obtained by extracting the graphite crystal peaks of the same DLC sample as used in FIG. 4 is shown in FIG. 6.

$$D = (0.9 \times \lambda)/(\beta \times \cos\theta) \cdots \text{Equation 1}$$

The parameters in Equation 1 are as follows:

D: crystal diameter (nm)
$\lambda$: wavelength of X-ray (nm)
$\beta$: half value width of crystal peak (radian)
$\theta$: position of crystal peak

The DLC film obtained has, as described above, an amorphous structure comprising carbon as a main component. The bonding form of carbons comprises both of a diamond structure ($SP^3$ structure) and a graphite structure ($SP^2$ structure). The film contains 10 to 35 atomic % of hydrogen.

In general, it is difficult to form the above DLC film on an iron base material, an aluminum alloy and the like with a good adhesive force. Therefore, the intermediate layer as an adhesive layer is provided as described above. More specifically, the intermediate layer is preferably a metal layer which contains at least one metal selected from, for example, Ti, Cr, W and Si, a metal nitride layer which contains said metal and a metal carbide layer which contains said metal. A total thickness of the intermediate layer is preferably 0.1 to 2.0 μm. That is, when the total thickness is less than 0.1 μm, the function of the intermediate layer is unsatisfactory. On the other hand, when the total thickness exceeds 2.0 μm, the impact resistance and the adhesive property are likely to be reduced because the hardness of the intermediate layer itself is low. The primer layer includes, to be specific, a film of metal selected from, for example, Ti, Cr, W and Si.

The sliding mechanism according to the present invention is constituted from the above-described lubricant oil composition and the sliding member. Because both of the lubricant oil composition and the sliding member have an excellent low-friction property, as described above, a sufficiently low friction coefficient can be obtained.

In the sliding member, the DLC film described above is formed on at least one of two sliding faces which slidably move relative to each other. The other sliding face of the opposite member is not specifically limited, i.e. a DLC film may be formed similarly thereon or may not be formed. As the material of the opposite member on which a DLC film is not formed, there may be mentioned an iron base material, an aluminum alloy material, etc. which are described above.

EXAMPLE

Next, the present invention will be described in further detail with reference to examples, but the present invention shall by no means be restricted to these examples.

Reference Example 1 and Examples 2 to 6 and Comparative Examples 1 to 4

The lubricant oil compositions having compositions shown in Table No. 1 were prepared and subjected to a frictional property test shown below to determine friction coefficients and abrasion depths. The results are shown in Table No. 1.

Incidentally, DLC containing 20% hydrogen was used for coating to obtain a DLC coated disc.

<Frictional Property Test>

A reciprocating friction tester (SRV reciprocating friction tester manufactured by Optimal Inc.) was used to measure friction coefficients by the following method.

A disc (diameter: 24 mm, thickness: 7.9 mm) coated with DLC was used as a test piece. Several droplets of a sample oil (lubricant oil composition) were dropped on the disc. A friction coefficient was determined under the test conditions including a load of 400 N, an amplitude of 1.5 mm, a frequency of 50 Hz and a temperature of 100°C in such a state that a cylinder (diameter: 15 mm, thickness: 22 mm) made of SCM420 was set on an upper part of the disc.

<Abrasion Depth Test>

Abrasion depth of the disc (DLC) was tested using a stylus roughness meter (Digital surfcorder DSF1000 manufactured by Kosaka Laboratory Ltd.). The maximum abrasion depth was measured from the profile of the trace of the sliding movement on the DLC coating that was obtained in the above frictional property test.
[Table 1]

Table No. 1-1

| | | Example | | | | | |
|---|---|---|---|---|---|---|---|
| | | 1* | 2 | 3 | 4 | 5 | 6 |
| Formulation Composition (% by mass) | Hydrorefined base oil | balance | balance | balance | balance | balance | balance |
| | Organomolybdenum compound A (p/q=0.13) | 0.20 | 0.30 | 0.40 | 0.80 | - | - |
| | Organomolybdenum compound B (p/q=0.30) | - | - | - | - | 1.00 | - |
| | Organomolybdenum compound C (p/q=0.32) | - | - | - | - | - | 1.02 |
| | Zinc dialkyldithiophosphate | 0.92 | 0.92 | 0.92 | 0.92 | 0.92 | 0.92 |
| | Sulfurized oxymolybdenum Dithiocarbamate (p/q=0.16) | - | - | - | - | - | - |
| | Viscosity index improving agent | 5.00 | 5.00 | 5.00 | 5.00 | 5.00 | 5.00 |
| | Pour point depressant | 0.10 | 0.10 | 0.10 | 0.10 | 0.10 | 0.10 |
| | Amine-type antioxidant | 0.60 | 0.60 | 0.60 | 0.60 | 0.60 | 0.60 |
| | Phenol-type antioxidant | 0.30 | 0.30 | 0.30 | 0.30 | 0.30 | 0.30 |
| | Metallic detergent A | 1.50 | 1.50 | 1.50 | 1.50 | 1.50 | 1.50 |
| | Metallic detergent B | 0.60 | 0.60 | 0.60 | 0.60 | 0.60 | 0.60 |
| | Polybutenylsuccinic acid bisimide | 3.00 | 3.00 | 3.00 | 3.00 | 3.00 | 3.00 |
| | Boronized polybutenylsuccinic acid monoimide | 1.50 | 1.50 | 1.50 | 1.50 | 1.50 | 1.50 |
| | Other additives | 0.50 | 0.50 | 0.50 | 0.50 | 0.50 | 0.50 |
| Properties of Composition | Molybdenum content (% by mass) | 0.02 | 0.03 | 0.04 | 0.08 | 0.08 | 0.08 |
| | Phosphorus content (% by mass) | 0.08 | 0.08 | 0.08 | 0.08 | 0.08 | 0.08 |
| | Sulfur content derived from organic molybdenum compound (ppm by mass) | 2 or less | 2 or less | 2 or less | 2 or less | 2 or less | 2 or less |
| Evaluation Results | Friction coefficient | 0.110 | 0.058 | 0.047 | 0.047 | 0.054 | 0.049 |
| | Abrasion depth of disc (DLC) (μm) | 0.00 | 0.00 | 0.00 | 0.00 | 0.00 | 0.00 |
| *Reference Example | | | | | | | |

[Table 2]

Table No. 1-2

| | | Comparative Example | | | |
|---|---|---|---|---|---|
| | | 1 | 2 | 3 | 4 |
| | Hydrorefined base oil | balance | balance | balance | balance |

(continued)

| | | Comparative Example | | | |
|---|---|---|---|---|---|
| | | 1 | 2 | 3 | 4 |
| Formulation Composition (% by mass) | Organomolybdenum compound A (p/q=0.13) | - | - | - | - |
| | Organomolybdenum compound B (p/q=0.30) | - | - | - | - |
| | Organomolybdenum compound C (p/q=0.32) | - | - | - | - |
| | Zinc dialkyldiphosphate | 0.92 | 0.92 | 0.92 | 0.92 |
| | Sulfurized oxymolybdenum dithiocarbamate (p/q=0.16) | - | 0.10 | 0.20 | 0.70 |
| | Viscosity index improving agent | 5.00 | 5.00 | 5.00 | 5.00 |
| | Pour point depressant | 0.10 | 0.10 | 0.10 | 0.10 |
| | Amine-type antioxidant | 0.60 | 0.60 | 0.60 | 0.60 |
| | Phenol-type antioxidant | 0.30 | 0.30 | 0.30 | 0.30 |
| | Metallic detergent A | 1.50 | 1.50 | 1.50 | 1.50 |
| | Metallic detergent B | 0.60 | 0.60 | 0.60 | 0.60 |
| | Polybutenylsuccinic acid bisimide | 3.00 | 3.00 | 3.00 | 3.00 |
| | Boronized polybutenylsuccinic acid monoimide | 1.50 | 1.50 | 1.50 | 1.50 |
| | Other additives | 0.50 | 0.50 | 0.50 | 0.50 |
| Properties of Composition | Molybdenum content (% by mass) | 0.00 | 0.01 | 0.02 | 0.07 |
| | Phosphorus content (% by mass) | 0.08 | 0.08 | 0.08 | 0.08 |
| | Sulfur content derived from organic molybdenum compound (ppm by mass) | 0 | 115 | 230 | 805 |
| Evaluation Results | Friction coefficient | 0.148 | 0.151 | 0.083 | 0.091 |
| | Abrasion depth of disc (DLC) (μm) | 0.00 | 0.00 | 0.99 | 1.28 |

Components used in the preparation of the lubricant oil compositions are as follows.

(1) Base oil A: Hydrorefined base oil (kinematic viscosity at 40°C: 21 $mm^2/s$; kinematic viscosity at 100°C: 4.5 $mm^2/s$; viscosity index: 127; $\%C_A$: 0.0; sulfur content: less than 20 ppm by mass; NOACK evaporation amount: 13.3% by mass)
(2) Organic molybdenum compound A: Trade name: "SAKURA-LUBE S-710" (manufactured by ADEKA Corporation), molybdenum content (q): 10% by mass, nitrogen content (p) : 1.3% by mass, sulfur content: 0.02% by mass;
(3) Organic molybdenum compound B: Trade name: "HiTEC4716" (manufactured by Afton Chemical Corporation), molybdenum content (q) : 8.0% by mass, nitrogen content (p) : 2.4% by mass, sulfur content: less than 0.02% by mass;
(4) Organic molybdenum compound C: Trade name: "MOLYVAN855" (manufactured by R. T. Vanderbilt Company Inc.), molybdenum content (q) : 7. 8% by mass, nitrogen content (p) : 2.5% by mass, sulfur content: less than 0.02% by mass;
(5) Zinc dialkyldithiophosphate: (Zn content: 9.0% by mass; phosphorus content: 8.2% by mass; sulfur content: 17.1% by mass, alkyl groups: mixture of secondary butyl group and secondary hexyl group);
(6) Sulfurized oxymolybdenum dithiocarbamate: Trade name: "SAKURA-LUBE 515" (manufactured by ADEKA Corporation), molybdenum content (q): 10.0% by mass, nitrogen content (p): 1.6% by mass, sulfur content: 11.5% by mass;
(7) Viscosity index improving agent: polymethacrylate (mass average molecular weight: 230,000)
(8) Pour point depressant: polyalkylmethacrylate (mass average molecular weight: 6,000)
(9) Amine-type antioxidant: dialkyldiphenylamine (nitrogen content: 3.4% by mass)
(10) Phenol-type antioxidant: octadecyl 3-(3,5-tert-butyl-4-hydroxyphenyl)propionate;

(11) Metallic detergent A: perbasic calcium salicylate, base number (perchlorate method): 350 mgKOH, calcium content: 12.1% by mass, sulfur content: 0.3% by mass;
(12) Metallic detergent B: neutral calcium sulfonate, base number (perchlorate method) : 17 mgKOH, calcium content: 2.4% by mass, sulfur content: 2.8% by mass;
(13) Polybutenylsuccinic acid bisimide: (average molecular weight of polybutenyl group: 2,000; base number (perchlorate method) : 11. 9 mg KOH/g, nitrogen content: 0.99% by mass; sulfur content: 0.18% by mass)
(14) Boronized polybutenylsuccinic acid monoimide: (average molecular weight of polybutenyl group: 1,000, base number (perchlorate method) : 25 mg KOH/g, nitrogen content: 1.23% by mass; boron content: 1.3% by mass;
(15) Other additives: rust preventing agent, surfactant and defoaming agent

From Table 1, it is seen that application of a lubricant oil composition of the present invention to the DLC coated disc (sliding face) can provide a low friction coefficient (excellent low-friction property) and a small abrasion depth (excellent wear resistance), (Examples 1 to 6). In contrast, the use of a lubricant oil composition which does not contain the organic molybdenum compound used in the present invention gives a high friction coefficient (fails to achieve low-friction property) (Comparative Examples 1 and 2) or gives a high abrasion depth (causes deterioration of wear resistance) (Comparative Examples 3 and 4).

INDUSTRIAL APPLICABILITY

The lubricating oil composition is applied to a sliding face having a low-friction sliding material such as a DLC material and is capable of imparting excellent low-frictional property and wear resistance thereto. In particular, when applied to internal combustion engines, the lubricant oil composition can give a fuel consumption-saving effect. Further, the sliding mechanism of the present invention in which the lubricant oil composition is allowed to be present is excellent in low-frictional property and wear resistance.

## Claims

1. Use of a lubricant oil composition for lubricating a low-friction sliding material being a diamond-like carbon (DLC) wherein

   the lubricant oil composition comprises an organic molybdenum compound which contains at least one nitrogen (N) atom in the molecule and which may optionally contain a sulfur (S) atom,
   wherein a sulfur content of said organic molybdenum compound is 0.5% by mass or less based on said organic molybdenum compound,
   the blending amount of the organic molybdenum compound is 0.03 to 0.2% by mass in terms of molybdenum based on a total weight of the composition and
   a mass ratio (p/q) of a nitrogen content (p) to a molybdenum content (q) in said organic molybdenum compound is 0.05 or more and 1.0 or less.

2. The use according to claim 1, wherein a content of sulfur derived from said organic molybdenum compound is 100 ppm by mass or less based on a total weight of said composition.

3. The use according to claim 1 or 2, wherein said organic molybdenum compound is at least one compound selected from the group consisting of (a) reaction products of a molybdenum compound and an amine compound, (b) reaction products of a molybdenum compound and an organic compound containing at least either one of a fatty acid and a fatty acid derivative, and at least one amino group and products obtained by sulfurizing the reaction products, and (c) reaction products of an acidic molybdenum compound or a salt thereof and a succinimide or carboxylic acid amide; and products obtained by sulfurizing the reaction products.

4. The use according to any one of claims 1 to 2, wherein the composition further comprises a zinc organodithiophosphate.

5. The use according to claim 4, wherein the zinc organodithiophosphate contains a hydrocarbon group having a secondary alkyl group.

6. A sliding mechanism in which the lubricant oil composition as defined in any one of claims 1 to 5 is present between sliding faces of two sliding members that slidably move relative to each other, wherein a diamond-like carbon (DLC)

film is formed on at least one of the sliding faces of the two sliding members.

7. The sliding mechanism according to claim 6, wherein the diamond-like carbon film has a graphite crystal peak in an X-ray scattering spectrum thereof.

8. The sliding mechanism according to claim 7, wherein the graphite crystals in the diamond-like carbon film has a crystal diameter of 15 to 100 nm, measured by employing X-ray diffraction measurement under the conditions as described in the description.

9. The sliding mechanism according to any one of claims 6 to 8, wherein at least one layer selected from a metal layer, which includes at least one metal selected from titanium (Ti), chromium (Cr), tungsten (W) and silicon (Si), a metal nitride layer which contains said at least one metal and a metal carbide layer which contains said at least one metal is provided between the sliding member and the diamond-like carbon film.

10. The sliding mechanism according to any one of claims 6 to 8, wherein the diamond-like carbon film is formed by a cathode PIG plasma CVD method in a high density plasma environment.

**Patentansprüche**

1. Verwendung einer Schmiermittel-Ölzusammensetzung zum Schmieren eines reibungsarmen Gleitmaterials, das ein Diamant-artiger Kohlenstoff (DLC) ist, worin die Schmiermittel-Ölzusammensetzung eine organische Molybdän-Verbindung enthält, die zumindest ein Stickstoff (N)-Atom im Molekül davon enthält und wahlweise ein Schwefel (S)-Atom enthalten kann,
worin ein Schwefel-Gehalt der organischen Molybdän-Verbindung 0,5 mass% oder weniger ist, bezogen auf die organische Molybdän-Verbindung,
die Mischungsmenge der organischen Molybdän-Verbindung 0,03 bis 0,2 mass% ist, ausgedrückt als Molybdän, bezogen auf ein Gesamtgewicht der Zusammensetzung, und
ein Massenverhältnis (p/q) eines Stickstoffgehaltes (p) zu einem Molybdän-Gehalt (q) in der organischen Molybdän-Verbindung 0,05 oder mehr und 1,0 oder weniger ist.

2. Verwendung nach Anspruch 1, worin ein Gehalt von Schwefel, der von der organischen Molybdän-Verbindung stammt, 100 mass-ppm oder weniger ist, bezogen auf das Gesamtgewicht der Zusammensetzung.

3. Verwendung nach Anspruch 1 oder 2, worin die organischen Molybdän-Verbindung zumindest eine Verbindung ist, ausgewählt aus der Gruppe bestehend aus (a) Reaktionsprodukten einer Molybdän-Verbindung und einer Amin-Verbindung, (b) Reaktionsprodukten einer Molybdän-Verbindung und einer organischen Verbindung, die zumindest eine von einer Fettsäure und einem Fettsäure-Derivat und zumindest eine Amino-Gruppe enthält, und Produkte, erhalten durch Sulfurisieren der Reaktionsprodukte, und (c) Reaktionsprodukten einer sauren Molybdän-Verbindung oder eines Salzes davon und eines Succinimides oder Carbonsäureamides und Produkte, erhalten durch Sulfurisieren der Reaktionsprodukte.

4. Verwendung nach einem der Ansprüche 1 bis 2, worin die Zusammensetzung weiterhin ein Zinkorganodithiophosphat enthält.

5. Verwendung nach Anspruch 4, worin das Zinkorganodithiophosphat eine Kohlenwasserstoff-Gruppe mit einer sekundären Alkyl-Gruppe enthält.

6. Gleitmechanismus, worin die Schmiermittel-Ölzusammensetzung wie in einem der Ansprüche 1 bis 5 definiert, zwischen Gleitflächen von zwei Gleitteilen vorhanden ist, die in bezug aufeinander gleitend sich bewegen, worin ein Diamant-artiger Kohlenstoff (DLC)-Film auf zumindest einer der Gleitoberflächen der beiden Gleitteile gebildet ist.

7. Gleitmechanismus nach Anspruch 6, worin der Diamant-artige Kohlenstoff-Film einen Graphit-Kristall-Peak in einem Röntgenbeugungsspektrum davon hat.

8. Gleitmechanismus nach Anspruch 7, worin die Graphit-Kristalle in dem Diamant-artigen Kohlenstoff-Film einen Kristalldurchmesser von 15 bis 100 nm haben, gemessen durch Anwendung einer Röntgenbeugungsmessung unter den Bedingungen, wie in der Beschreibung angegeben.

9. Gleitmechanismus nach einem der Ansprüche 6 bis 8, worin zumindest eine Schicht, ausgewählt aus einer Metallschicht, die zumindest ein Metall enthält, ausgewählt aus Titan (Ti), Chrom (Cr), Wolfram (W) und Silicium (Si), einer Metallnitrid-Schicht, die zumindest ein Metall enthält, und einer Metallcarbid-Schicht, die das zumindest eine Metall enthält, zwischen dem Gleitteil und dem Diamant-artigen Kohlenstoff-Film vorgesehen ist.

10. Gleitmechanismus nach einem der Ansprüche 6 bis 8, worin der Diamant-artige Kohlenstoff-Film durch ein Kathoden-PIG-Plasma-CVD-Verfahren in einer Plasma-Umgebung mit hoher Dichte gebildet ist.

## Revendications

1. Utilisation d'une composition d'huile lubrifiante pour lubrifier un matériau de glissement à faible frottement étant un carbone sous forme de diamant amorphe (DLC)
dans lequel la composition d'huile lubrifiante comprend un composé organique de molybdène qui contient au moins un atome d'azote (N) dans la molécule et qui peut facultativement contenir un atome de soufre (S),
dans lequel une teneur en soufre dudit composé organique de molybdène est de 0,5 % en masse ou moins sur la base dudit composé organique de molybdène,
la quantité de mélange du composé organique de molybdène est de 0,03 à 0,2 % en masse en termes de molybdène sur la base d'un poids total de la composition, et
un rapport de masses (p/q) d'une teneur en azote (p) à une teneur en molybdène (q) dans ledit composé organique de molybdène est de 0,05 ou plus et de 1,0 ou moins.

2. Utilisation selon la revendication 1, dans lequel une teneur en soufre issue dudit composé organique de molybdène est de 100 ppm en masse ou moins sur la base d'un poids total de ladite composition.

3. Utilisation selon la revendication 1 ou 2, dans laquelle ledit composé organique de molybdène est au moins un composé sélectionné à partir du groupe constitué par (a) des produits de réaction d'un composé de molybdène et d'un composé d'amine, (b) des produits de réaction d'un composé de molybdène et d'un composé organique contenant au moins l'un ou l'autre d'un acide gras et d'un dérivé d'acide gras, et au moins un groupe amino et des produits obtenus en sulfurisant les produits de réaction, et (c) des produits de réaction d'un composé acide de molybdène ou d'un sel de celui-ci et d'un succinimide ou d'un amide d'acide carboxylique ; et des produits obtenus en sulfurisant les produits de réaction.

4. Utilisation selon l'une quelconque des revendications 1 à 2, dans laquelle la composition comprend en outre un organodithiophosphate de zinc.

5. Utilisation selon la revendication 4, dans laquelle l'organodithiophosphate de zinc contient un groupe hydrocarbure ayant un groupe alkyle secondaire.

6. Mécanisme de glissement dans lequel la composition d'huile lubrifiante selon l'une quelconque des revendications 1 à 5 est présente entre des faces de glissement de deux éléments de glissement qui se déplacent de manière glissante l'une par rapport à l'autre, dans lequel un film de carbone sous forme de diamant amorphe (DLC) est formé sur au moins l'une des faces de glissement des deux éléments de glissement.

7. Mécanisme de glissement selon la revendication 6, dans lequel le film de carbone sous forme de diamant amorphe a un pic de cristal de graphite dans un spectre de diffusion des rayons X de celui-ci.

8. Mécanisme de glissement selon la revendication 7, dans lequel les cristaux de graphite dans le film de carbone sous forme de diamant amorphe ont un diamètre de cristal de 15 à 100 nm, mesuré en utilisant une mesure de diffraction des rayons X dans les conditions telles que décrites dans la description.

9. Mécanisme de glissement selon l'une quelconque des revendications 6 à 8, dans lequel au moins une couche sélectionnée parmi une couche de métal, qui comprend au moins un métal sélectionné à partir du titane (Ti), du chrome (Cr), du tungstène (W) et du silicium (Si), une couche de nitrure métallique qui contient ledit au moins un métal et une couche de carbure métallique qui contient ledit au moins un métal est fournie entre le matériau de glissement et le film de carbone sous forme de diamant amorphe.

10. Mécanisme de glissement selon l'une quelconque des revendications 6 à 8, dans lequel le film de carbone sous

forme de diamant amorphe est formé par un procédé de CVD par plasma PIG sur la cathode dans un environnement de plasma haute densité.

[FIG.1]

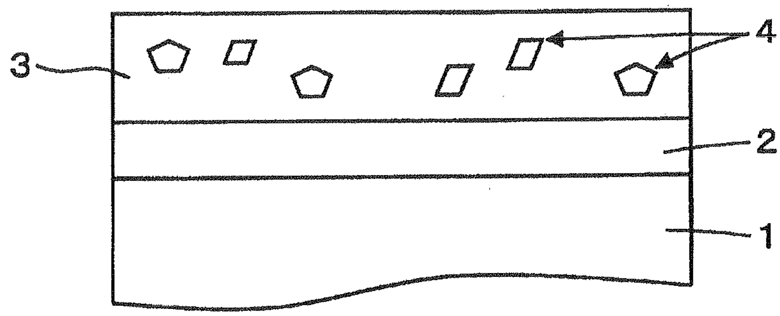


[FIG.2]

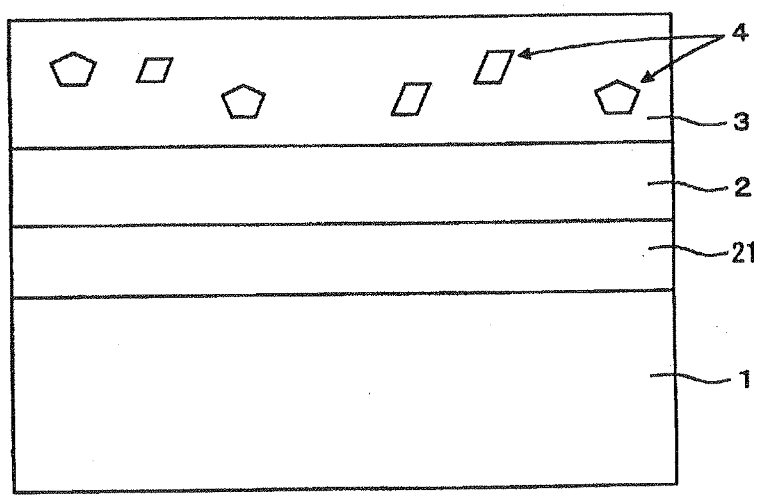

[FIG.3]

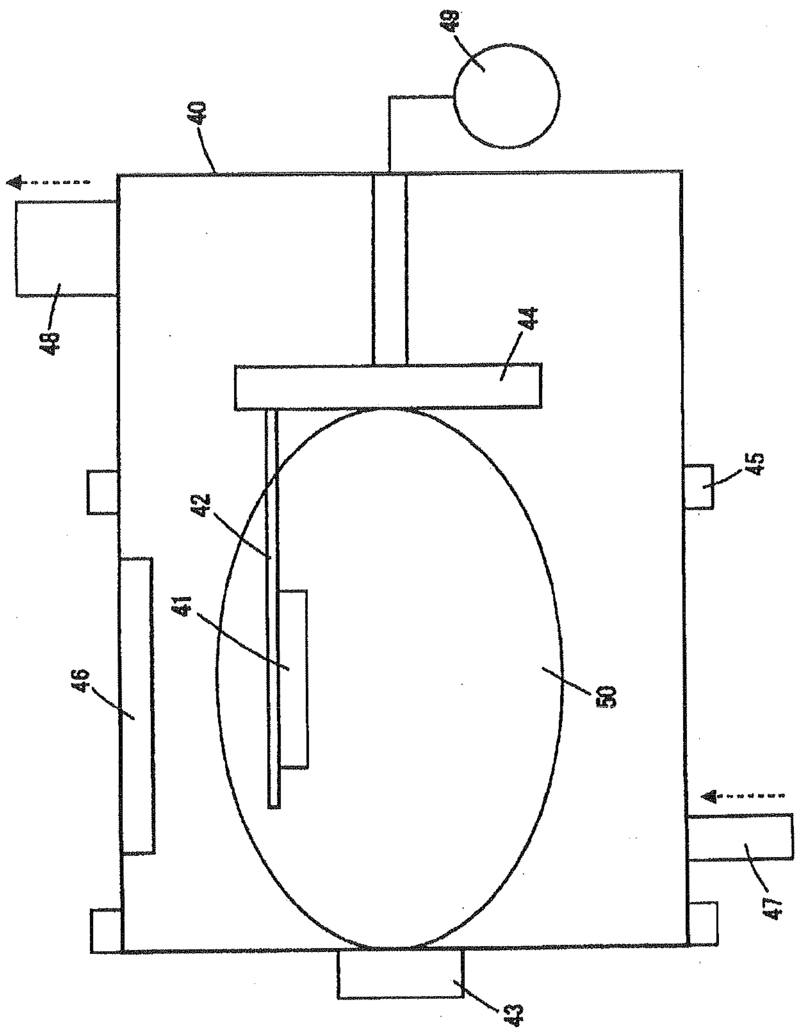

[FIG.4]

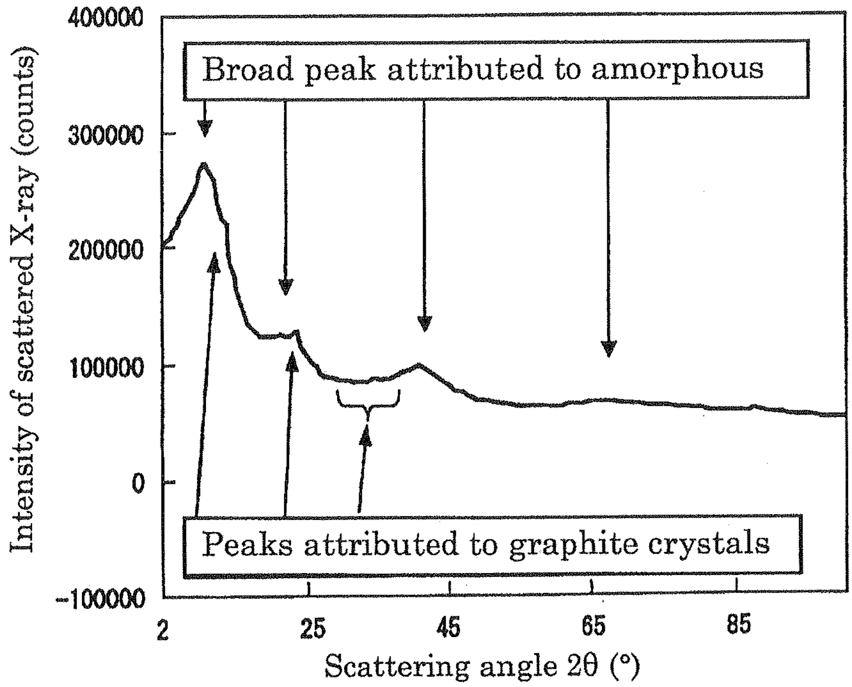
Broad peak attributed to amorphous
Peaks attributed to graphite crystals
Intensity of scattered X-ray (counts)
400000
300000
200000
100000
0
-100000
2
25
45
65
85
Scattering angle 2θ (°)

[FIG.5]

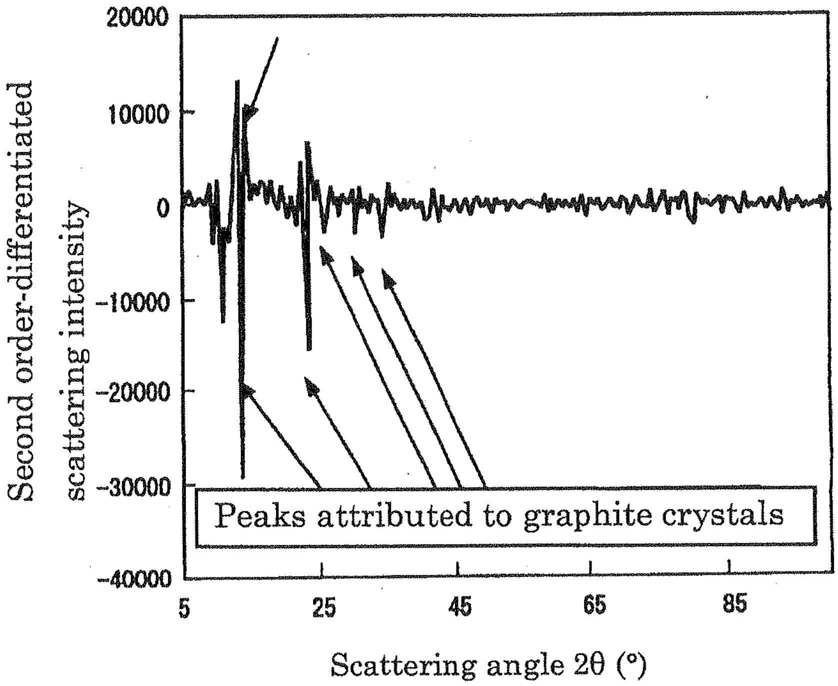
Second order-differentiated scattering intensity
20000
10000
0
-10000
-20000
-30000
-40000
Peaks attributed to graphite crystals
5
25
45
65
85
Scattering angle 2θ (°)

[FIG.6]

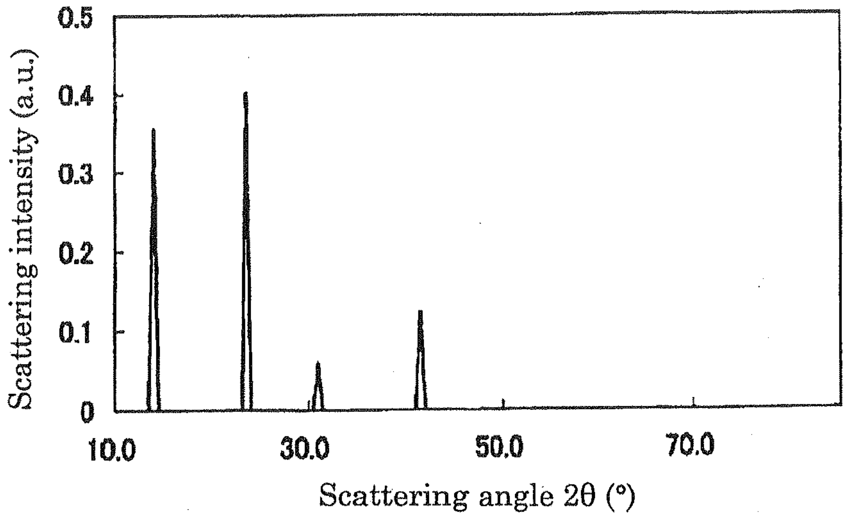
0.5
0.4
0.3
0.2
0.1
0
Scattering intensity (a.u.)
10.0
30.0
50.0
70.0
Scattering angle 2θ (°)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009215406 B
- JP 2006036850 A
- JP 2003238982 A
- JP 2004155891 A
- JP 2005098495 A
- JP 2003252887 A
- JP 2757174 B
- US 5412130 A
- US 4889647 A
- US 5137647 A
- JP 3291339 B
- JP 4109428 B
- JP 4109429 B
- JP 2004002866 A
- JP 2008335718 A